Europäisches Patentamt

European Patent Office

Office européen des brevets

(11) Numéro de publication: **0 285 200**

**A1**

## (12) DEMANDE DE BREVET EUROPEEN

(21) Numéro de dépôt: 88200475.7

(51) Int. Cl.⁴: **H04N 3/27** , H03K 4/62

(22) Date de dépôt: **14.03.88**

(30) Priorité: **20.03.87 FR 8703898**

(43) Date de publication de la demande:
**05.10.88 Bulletin 88/40**

(84) Etats contractants désignés:
**DE FR GB IT**

(71) Demandeur: **S.A. La Radiotechnique
Industrielle et Commerciale
51 Rue Carnot
F-92150 Suresnes(FR)**

(84) **FR**

(71) Demandeur: **N.V. Philips'
Gloeilampenfabrieken
Groenewoudseweg 1
NL-5621 BA Eindhoven(NL)**

(84) **DE GB IT**

(72) Inventeur: **Dauvillier, Richard Société Civile
S.P.I.D.
209, rue de l'Université
F-75007 Paris(FR)**
Inventeur: **Giordano, Henri Société Civile
S.P.I.D.
209, rue de l'Université
F-75007 Paris(FR)**

(74) Mandataire: **Caron, Jean et al
SOCIETE CIVILE S.P.I.D. 209, rue de
l'Université
F-75007 Paris(FR)**

(54) **Circuit de balayage ligne et de génération de tension.**

(57) Circuit de balayage lignes alimentant en courant en dents de scie un bobinage de déflexion (Ly) et fournissant des tensions auxiliaires (3) au moyen d'un transformateur (TR). Les courants du bobinage et du transformateur sont tous deux découpés ensemble par un même interrupteur (T1) mais ces éléments selfiques sont séparés par des diodes (D1, D2) et associés chacun à un ensemble constitué d'une diode et d'un condensateur (respectivement D3-C3 et D4-C4) pour fournir le courant pendant les retours de lignes et le début du balayage aller. L'ensemble est caractérisé par le fait que le transformateur (TR) et le bobinage (Ly) sont alimentés indépendamment l'un de l'autre pour permettre une variation d'amplitude de balayage sans modification de la THT (3). Application aux moniteurs multistandard associés à des systèmes de traitements de données.

FIG. 3

la

## "Circuit de balayage ligne et de génération de tension".

La présente invention concerne un circuit de balayage ligne et de génération de tension d'accélération pour un tube à images à rayons cathodiques, comportant un transformateur destiné à fournir une tension d'accélération, branché entre une source d'alimentation et un élément interrupteur à semiconducteur, lequel est relié également à une bobine de déflexion magnétique et à un ensemble constitué d'un condensateur dit "de retour" en parallèle avec une diode, cet ensemble constituant un chemin de courant en parallèle sur celui de l'interrupteur, la diode étant passante dans le sens opposé à celui de l'interrupteur, le circuit comportant une diode de séparation qui est insérée entre le transformateur et la bobine de déflexion, et dont le sens de branchement permet le passage du courant de l'interrupteur, et un deuxième ensemble constitué d'un condensateur de retour et d'une diode, deuxième ensemble qui est connecté à la diode de séparation du côté opposé à celui qui est relié à l'interrupteur.

On souhaite utiliser un tel circuit dans des moniteurs destinés à l'affichage de textes alphanumériques et/ou d'images synthétiques.

Le document FR-A-2 493 651 décrit un circuit qui correspond au préambule ci-dessus. Le problème qu'il résoud consiste à éviter des suroscillations et des défauts de linéarité, mais il n'envisage pas le problème de l'obtention de plusieurs standards avec des amplitudes ligne différentes.

L'invention se propose de fournir un dispositif permettant d'utiliser un même moniteur pour plusieurs systèmes de traitement d'information, ces systèmes ayant chacun des caractéristiques différentes qui amènent notamment l'obligation de fournir pour le moniteur selon le système de traitement d'information qui lui est associé, différentes amplitudes de balayage ligne, et ceci en conservant bien entendu une tension d'accélération constante du tube à rayons cathodiques.

A cet effet, le circuit selon l'invention est remarquable en ce que la bobine de déflexion est reliée à une source de tension d'alimentation différente de celle à laquelle est relié le transformateur.

Dans le cas où la différence entre la tension sur le transformateur et celle sur la bobine est susceptible de s'inverser selon les modes de fonctionnement il est avantageux de prévoir une deuxième diode de séparation branchée en série avec la première dans la liaison qui va de la bobine de déflexion au transformateur, les deux diodes de séparation étant en opposition l'une vis à vis de l'autre, l'élément interrupteur étant connecté au point commun de ces deux diodes, et de connecter chacun des deux susdits ensembles à une des deux diodes de séparation du côté opposé au point commun de ces diodes.

Pour assurer une correction de linéarité dite "en S" il est habituel d'installer un condensateur simplement placé en série avec le bobinage de déflexion. Dans le cas présent ce bobinage est toutefois relié à une source de tension et on ne peut procéder de la manière habituelle. On a constaté qu'il est néanmois possible d'assurer une correction en S lorsque, du côté qui est relié à sa source d'alimentation, la bobine de déflexion est connectée à une électrode d'un condensateur dit de S, dont l'autre électrode est reliée à la masse, et qu'une diode est insérée entre la source d'alimentation et la bobine.

Un mode de réalisation avantageux est remarquable en ce que la diode qui est branchée en parallèle sur le condensateur de retour du système de déflexion est connectée, de son côté opposé à celui qui est relié à ce système, à une source de tension continue engendrée au moyen du transformateur.

L'emploi du circuit selon l'invention est particulièrement interessant lorsque les différents modes de fonctionnement envisagés utilisent tous la même fréquence de balayage ou au moins des fréquences voisines. On conserve alors sensiblement toujours le même temps d'aller et de retour de ligne et deux amplitudes différentes de balayage peuvent être obtenues au moyen d'une source de tension réglable pour la bobine ainsi que de moyens pour choisir cette tension parmi au moins deux valeurs différentes.

La description qui va suivre, en regard des dessins annexés décrivant des exemples non limitatifs fera bien comprendre comment l'invention peut être réalisée.

Les figures 1A et 1b représentent des formes de courant de balayage pour illustrer un problème particulier auquel le circuit selon l'invention apporte une solution.

La figure 2 est un schéma simplifié d'une première variante de l'invention.

La figure 3 est un schéma simplifié d'une seconde variante de l'invention.

La figure 4 est un schéma détaillé de la variante représentée par la figure 3.

L'exemple de réalisation décrit ci-dessous concerne le cas on l'on souhaite utiliser le même tube cathodique, avec ses circuits associés, pour d'une part assurer une fonction de réception Teletex, dite "Minitel", permettant l'affichage de données reçues par téléphone en réponse à des paramètres choisis localement, et d'autre part servir de moniteur à des microordinateurs, notamment ceux appelés "compatibles PC", et dont les moniteurs ont des caractéristiques différentes de celles des récepteurs Teletex.

Du point de vue matériel, cela signifie que l'on doit assurer des balayages répondant au normes suivantes :

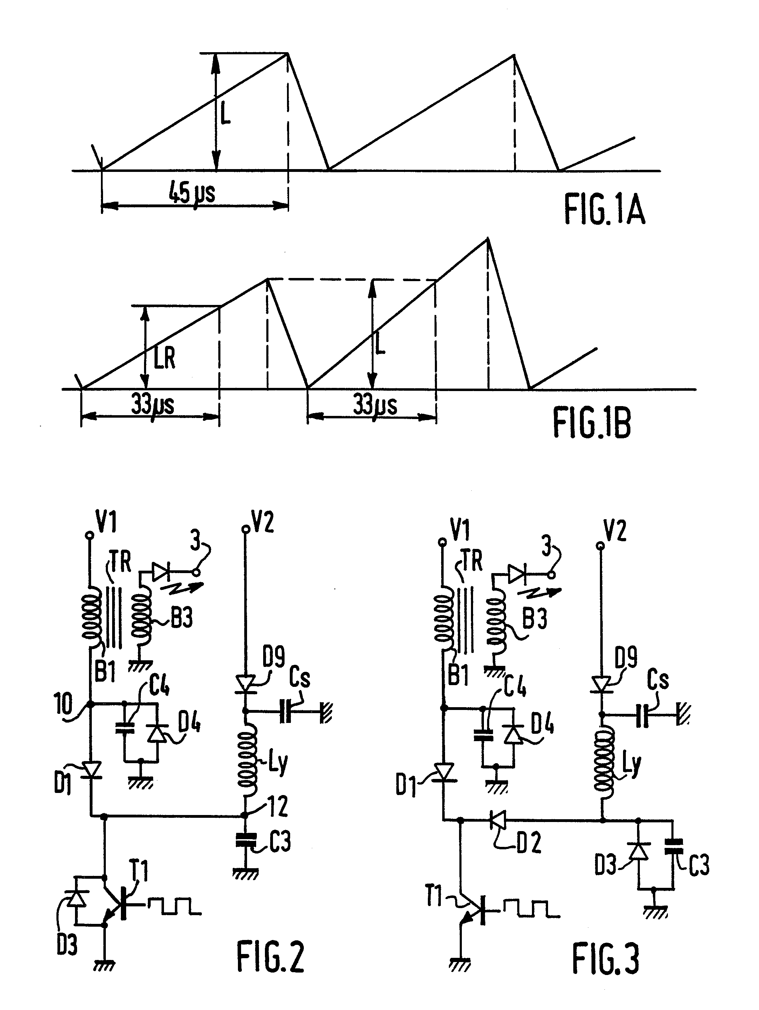

la figure 1A représente le courant de balayage nécessaire pour le moniteur de microordinateur. Sa fréquence de répétition est de 18432 Hz pour 369 lignes par trame (correspondant à peu près à une trame à 50 Hz). La période totale du signal est de 54,25$\mu$S. La partie utile de la période d'aller, c'est-à-dire celle pendant laquelle le processeur vidéo du microordinateur fournit des données, dure 45$\mu$S. Une durée de retour de 8,4$\mu$S est prévue, ce qui laisse donc une petite marge de 0,85$\mu$S pour l'aller. L'amplitude de la largeur d'image ap paraissant sur l'écran est proportionnelle à la grandeur L indiquée sur la figure.

Pour simplifier la réalisation on a voulu conserver à peu près la même fréquence de balayage lors de l'usage en vidéotex, ceci afin d'éviter toute commutation au niveau de l'oscillateur lignes, aussi bien qu'au niveau de l'étage de puissance. On a donc choisi, toujours pour simplifier la mise au point, d'utiliser des logiciels préexistants pour gérer les traitements de données sur vidéotex, et aussi le processeur vidéo correspondant. Celui-ci est prévu pour fournir 312 lignes à 50 Hz, soit une fréquence de balayage de 15600 Hz. Pour amener cette fréquence près de celle obtenue dans le mode décrit plus haut, on a tout simplement accéléré l'horloge du microprocesseur, de manière à obtenir sensiblement 60 trames par seconde. On obtient donc une fréquence lignes de 18720 Hz. Mais la durée utile du balayage normal du vidéotex (50Hz) est de 40$\mu$S et celle du processeur, ainsi accéléré de 20%, est donc de 33 1/3$\mu$S. La partie gauche de la figure 1B représente la même dent de scie que la figure 1A : avec une durée utile d'environ 33$\mu$S la largeur utile d'image est indiquée par LR : elle est beaucoup plus petite que dans l'autre cas et il y a à droite de l'écran une bande inutilisée relativement large. Pour obtenir une image satisfaisante, il faut qu'au bout d'une durée de 33 $\mu$S le balayage ait atteint la même amplitude que dans le cas de la figure 1A. Un balayage satisfaisant cette condition est représenté à droite sur la figure 1B : il fournit la même largeur L que dans la figure 1A, au bout de 33$\mu$S seulement. Son amplitude maximale est donc environ 45/33 fois plus grande que dans le cas de la figure 1A. Bien entendu tout le reste du dispositif d'affichage soit rester inchangé, et en particulier les tensions d'accélération du tube à rayons cathodiques.

Le schéma de la figure 2 montre qu'à une source de tension d'alimentation V1 est branché le bobinage primaire B1 d'un transformateur TR dont un enroulement secondaire B3 fournit sur une borne 3 la très haute tension d'accélération du tube à rayon cathodique (dans le cas présent : 12 kV). Au tra vers de la diode D1 ce transformateur est relié au collecteur d'un transistor T1 dont l'émetteur est à la masse et qui joue le rôle d'un interrupteur. Sa base est commandée à la fréquence ligne par un circuit connu non représenté. Cet interrupteur commande le courant d'une bobine de déflexion Ly dont une extrémité est reliée aussi au collecteur du transistor T1 et dont l'autre extrémité est reliée à la masse via un condensateur Cs qui assure la correction en S. On suppose pour l'instant la diode D1 court-circuitée. Lorsque le transistor T1 est coupé, le courant magnétisant du transformateur TR et celui de la bobine de déflexion Ly peut,au début de la période dite de retour, continuer à circuler dans le condensateur C3 dit "de retour". D'une manière connue ce courant change rapidement de sens cependant qu'une surtension se développe et fournit la très haute tension aux bornes de B3, après quoi le courant dans l'autre sens peut passer par la diode D3 qui est placée en parallèle sur le transistor T1, et est passante pour un courant opposé à celui dans le transistor. Le courant "retourné" passe par la diode D3 pendant le début de la période d'aller jusqu'au moment ou il s'inverse et passe par le transistor T1 qui a été rendu à nouveau conducteur entre temps. L'ensemble du condensateur C3 et de la diode D3 constitue un chemin de courant en parallèle avec celui de l'interrupteur T1.

Cependant, une diode de séparation D1 est insérée entre le primaire B1 du transformateur TR et la bobine de déflexion Ly, c'est-à-dire entre les points 10 et 12 de la figure. Dans l'exemple représenté par la figure 2, le transistor T1 est branché à cette diode du côté de la bobine Ly, et c'est la cathode de la diode qui est tournée vers le transistor NPN, de manière à permettre le passage du courant principal de l'interrupteur T1.

La diode D1 empêche notamment le courant retourné à la fin de la période de retour, et au début de la période d'aller, courant passant par le condensateur C3 puis par la diode D3, d'atteindre le transformateur. Pour assurer un fonctionnement correct pendant les périodes correspondantes, un deuxième ensemble constitué d'un condensateur de retour C4 et d'une diode D4 est ajouté et connecté entre l'extrémité active du bobinage B1 du transformateur et la masse. Ce deuxième ensemble joue donc vis à vis de la self-inductance du primaire B1 le même rôle que celui du premier ensemble C3-D3, rôle que ce dernier ne joue plus maintenant que pour le bobinage de déflexion Ly. Le montage tel que décrit jusqu'ici pourrait fonctionner... mais son fonctionnement serait sensiblement identique sans les éléments D1, C4. D4 Une dernière disposition donne tout son intérêt au circuit : l'autre côté de la bobine de déflexion Ly par rapport à celui qui est relié à l'interrupteur, est relié à une source de tension V2 qui est différente de celle à laquelle est relié le transformateur. La diode D1 empêche la source V2 de fournir un courant au transformateur. La partie comportant la bobine de déflexion fonctionne donc sous la tension V2 et celle fournissant la tension d'accélération sous la tension V1. On peut alors faire varier V2 et modifier en conséquence l'amplitude du balayage sans que la tension d'accélération sur la borne 3 ne varie.

Pour obtenir une correction en S, la bobine Ly n'est pas reliée directement à l'alimentation V2 : une diode D9 est placée en série dans l'alimentation et un condensateur Cs dit "de S" est connecté entre la bobine et la masse.

Ce montage fonctionne sans problème tant que la tension, au moins pendant les durées de retour de balayage, est plus forte sur la bobine Ly que sur le primaire B1 du transformateur, afin que la diode D1 soit bloquée.

Un autre mode de réalisation (non représenté mais peu différent de celui de la figure 2) est possible selon la même définition. La diode D1 étant toujours branchée entre le transformateur et la bobine, l'élément interrupteur T1 peut être connecté à cette diode du côté du transformateur (au point 10).

Alors la diode sera branchée dans le sens opposé à celui représenté sur la figure 2. Comme dans ce cas la diode D3 associée à T1 est reliée au point 10 la diode D4 devient inutile, mais par contre il est nécessaire d'en prévoir une en parallèle sur C3. Ce mode de réalisation convient dans le cas opposé à celui mentionné plus haut c'est-à-dire maintenant dans le cas où la tension reste toujours plus faible sur la bobine que sur le transformateur.

Il peut cependant se produire, notamment lorsqu'on utilise certains composants disponibles, par exemple la bobine de déflexion Ly, que pour certaines valeurs désirées de l'alimentation V2 la tension soit plus forte sur la bobine que sur le transformateur alors que pour d'autres valeurs de l'alimentation V2, le contraire se produit. Dans ce cas le schéma de la figure 3 fournit une solution. Il comporte les mêmes éléments que celui de la figure 2 portant les mêmes références, mais une deuxième diode de séparation D2 est ajoutée. Elle est insérée entre la bobine de déflexion Ly et l'élément interrupteur T1. Le premier ensemble constitué de la diode D3 et du condensateur C3 est branché à l'anode de la diode D2 c'est-à-dire du côté opposé au point commun des deux diodes, et de même l'ensemble C4-D4 est branché à l'anode de D1. Les deux diodes sont en opposition et leur sens de branchement permet à leurs courants de s'écouler par le transistor T1 qui est branché à leur point commun.

Le transistor de puissance T1 comporte une diode de retour intégrée. C'est pourquoi dans la figure 2 la diode D3 est représentée directement aux bornes du transistor. Dans le schéma de la figure 3 il est nécessaire d'ajouter une diode D3 distincte, afin qu'elle soit séparée du transistor T1 par la diode D2. Avec le schéma de la figure 3, la tension V2 peut être choisie librement vis à vis de la tension V1.

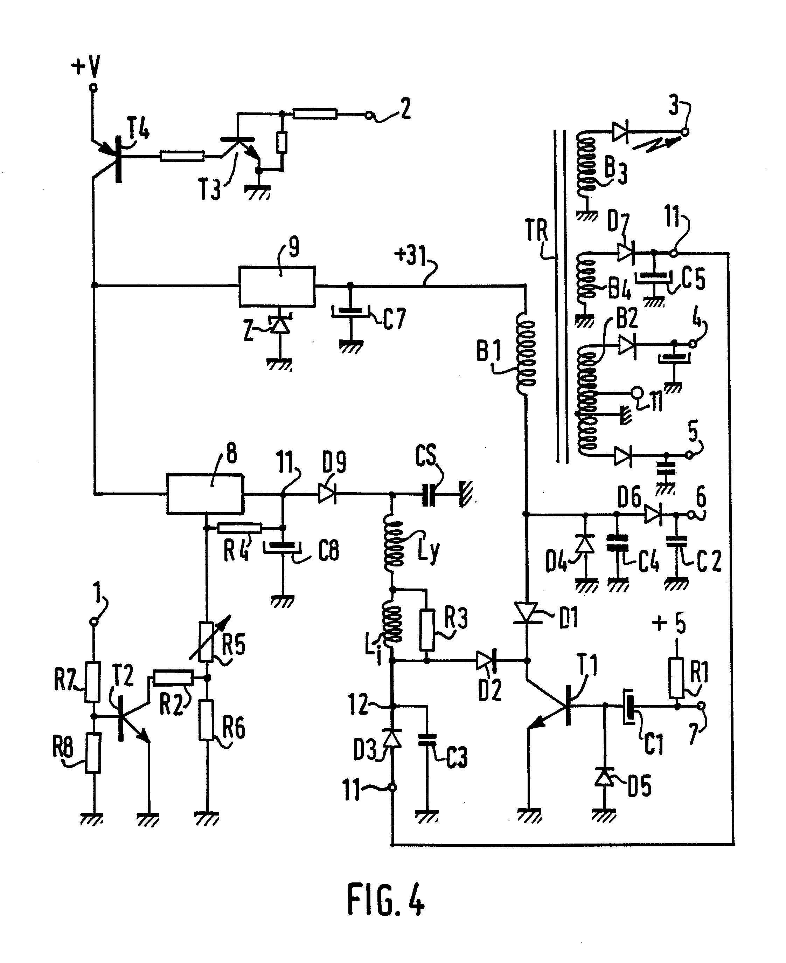

La figure 4 représente en détail une forme de réalisation préférée de l'invention. A partir d'une source de tension positive +V sont alimentés deux circuits stabilisateurs de tension 8 et 9. Le transistor PNP T4 en série dans la source +V permet de couper l'alimentation pour obtenir un état dit "de veille". Le transistor T4 est commandé de façon habituelle par un autre transistor T3 dont la base est reliée à une borne 2 de commande de veille.

Le circuit intégré 9 fournit une tension fixe de 31 Volts à un condensateur réservoir C7. En l'absence d'un modèle délivrant une tension suffisante, une diode zener Z est ajoutée pour relever la tension de la borne de référence du circuit 9. La tension +31 est appliquée au bobinage B1 du transformateur TR. Ce dernier comporte un secondaire B3 déjà mentionné dont la tension redressée fournit la THT sur la borne 3. Un autre secondaire B2 fournit de manière connue différentes tensions annexes sur les bornes 4, 5, 11.

Les différents éléments D4, C4, D1, T1 correspondent à ceux de la figure 3. On profite de la surtension de retour aux bornes du primaire pour fournir une alimentation annexe supplémentaire, au moyen de la diode D6, sur le condensateur réservoir C2 et la borne 6.

Le transistor T1, est commandé de façon connue par un condensateur de liaison C1 et une diode de restitution de composante continue D5, à partir d'une borne de commande 7 reliée à un circuit intégré non représenté, par exemple du modèle TEA 2037A disponible dans le commerce, et chargé par une résistance R1 reliée à une alimentation +5 de cinq volts.

Le circuit intégré stabilisateur 8 fournit une tension à un condensateur réservoir C8 et alimente le bobinage Ly et le condensateur Cs de correction en S, au travers d'une diode D9. Ces éléments sont les mêmes que ceux de la figure 3. Une self de linéarité L en parallèle avec une résistance R3 sont branchés en série avec la bobine de déflexion.

Les éléments D2, D3, C3 enfin sont les mêmes que ceux de la figure 3 : on suppose pour le moment que la borne 11 est reliée à la masse.

Le circuit intégré 8 délivre une tension qui est fonction de la valeur de division d'un diviseur résistif constitué, entre la borne de sortie 11 et la masse, par les résistances R4, R5, R6 en série. Entre le point commun de R5 et de R6 et la masse est branchée un transistor T2 en série avec une résistance R2, dont le rôle est de changer la valeur de division du pont et par conséquent la tension délivrée par le circuit intégré 8. La base de ce transistor T2 est commandée par un pont de résistances R7, R8, à partir d'une borne 1 de commande de mode, dont les niveaux sont compatibles TTL. Lorsque la tension en 1 est haute le transistor T2 est passant et la résistance R2 vient en parallèle sur R6. Ce cas correspond à l'usage "Minitel". Si la tension en 1 est basse, le pied du pont de réglage de tension est constitué par R5 en série avec R6 et la tension sur la borne 11 est alors plus basse : ce cas correspond à l'usage "compatible PC". En outre, la résistance R5 est ajustable, ce qui permet de régler la tension. Dans la première partie de l'aller du balayage, le courant dans la diode D3 engendre une tension (négative) d'environ -0,6 volt sur la connexion 12. Lorsqu'ensuite le courant passe par la diode D2 et le transistor T1, cette tension est au contraire positive. L'introduction de la diode D2 en série avec le transistor T1 augmente cette tension, qui peut atteindre environ +1,5 volt, dans le cas ou le transistor T1 est un modèle Darlington. Lorsque les tensions d'alimentation employées sont relativement faibles, la différence de tension aux bornes du déflecteur Ly entre le début et la fin de l'aller est inadmissible.

Cette difficulté est résolue du fait que la diode D3, celle qui est branchée en parallèle sur le condensateur de retour C3 du système de déflexion, est connectée, de son côté opposé à celui 12 qui est relié à ce système, à une borne 11 qui est reliée à une source de tension engendréepar un bobinage B4 du transformateur, tension qui est redressée par une diode D7 et lissée par un condensateur C5 pour fournir une tension continue positive à la borne 11. Grâce à cette disposition, la tension sur la connexion 12 est remontée, pendant le début d'aller de balayage. Il faut bien entendu absolument éviter que la source de tension en question puisse débiter via les élément D3, D2, T1 en cascade, lorsque T1 est conducteur ! Sa tension est donc en pratique limitée à une valeur légèrement inférieure à la somme des tensions de seuil ou de saturation de ces éléments D3, D2, T1.

Le transformateur est un modèle conçu de manière à présenter la plus grande inductance primaire compatible avec l'obtention de l'habituel accord sur harmonique trois.

Il faut noter que s'il existait un transistor de puissance à deux collecteurs, un tel transistor pourrait jouer à lui seul le rôle du transistor T1 et des deux diodes D1 et D2 : l'un des collecteurs serait alors branché au transformateur et l'autre au bobinage de déflection.

Les choix suivants pour les éléments ont permis d'obtenir de bons résultats :

| | | | | |
|---|---|---|---|---|
| $R_1$ | 100 Ω | | $C_1$ | 2,2 µF |
| $R_2$ | 24 KΩ | | $C_2$ | 22 nF |
| $R_3$ | 1 KΩ | | $C_3$ | 15 nF |
| $R_4$ | 390 Ω | | $C_4$ | 15 nF |
| $R_5$ | 2K2 Ajustable | | | |
| $R_6$ | 6K8 | | $C_7$ | 47µF |
| $R_7$ | 22KΩ | | $C_8$ | 47µF |
| $R_8$ | 10KΩ | | $C_9$ | 1,8µF |

D1 à D4 BYD 335
D5    1N4148
D6, D7 BYD 335
T1    BU 806
T2    BC 548 B
T3    BC 548 C
T4    BD 136
Z    BZX55 C6V8
8 :    LM317 régulateur variable
9 :    78 M 24 régulateur fixe

Ly = RT 1077/04A
Li = AT 4042/46
tension sur la borne 11 : 2 volts

## Revendications

1. Circuit de balayage ligne et de génération de tension d'accélération pour un tube à images à rayons cathodiques, comportant un transformateur destiné à fournir une tension d'accélération, branché entre une source d'alimentation et un élément interrupteur à semiconducteur, lequel est relié également à une bobine de déflexion magnétique et à un ensemble constitué d'un condensateur dit "de retour" en parallèle avec une diode, cet ensemble constituant un chemin de courant en parallèle sur celui de l'interrupteur, la diode étant passante dans le sens opposé à celui de l'interrupteur, le circuit comportant une diode de séparation qui est insérée entre le transformateur et la bobine de déflexion, et dont le sens de branchement permet le passage du courant de l'interrupteur, et un deuxième ensemble constitué d'un condensateur de retour et d'une diode, deuxième ensemble qui est connecté à la diode de séparation du côté opposé à celui qui est relié à l'interrupteur, caractérisé en ce que la bobine de déflexion est reliée à une source de tension d'alimentation différente de celle à laquelle est relié le transformateur.

2. Circuit selon la revendication 1, caractérisé en ce qu'il comporte une deuxième diode de séparation branchée en série avec la première dans la liaison qui va de la bobine de déflexion au transformateur, les deux diodes de séparation étant en opposition l'une vis à vis de l'autre, l'élément interrupteur étant connecté au point commun de ces deux diodes, et en ce qui chacun des deux susdits ensembles est connecté à une des deux diodes de séparation du côté opposé au point commun de ces diodes.

3. Circuit selon l'une des revendications 1 ou 2, caractérisé en ce que du côté qui est relié à sa source d'alimentation, la bobine de déflexion est connectée à une électrode d'un condensateur dit "de S", dont l'autre électrode est reliée à la masse, et en ce qu'une diode est insérée entre la source d'alimentation et la bobine.

4. Circuit selon l'une quelquonque des revendication précédentes, caractérisé en ce que la source de tension d'alimentation de la bobine est réglable et que des moyens sont prévus pour choisir sa tension parmi au moins deux valeurs différentes.

5. Circuit selon l'une quelconque des revendications précédentes, caractérisé en ce que la diode qui est branchée en parallèle sur le condensateur de retour du système de déflexion est connectée, de son côté opposé à celui qui est relié à ce système, à une source de tension continue engendrée au moyen du transformateur.

**FIG.1A**

**FIG.1B**

**FIG.2**

**FIG.3**

FIG. 4

**Office européen des brevets**

# RAPPORT DE RECHERCHE EUROPEENNE

Numero de la demande

EP 88 20 0475

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.4) |
|---|---|---|---|
| X | IMB TECHNICAL DISCLOSURE BULLETIN, vol. 22, no. 8A, janvier 1980, pages 3380-3381, New York, US; D.M. TAUB: "Line deflection/eht generator circuit for CRT display" * En entier * --- | 1 | H 04 N 3/27<br>H 03 K 4/62 |
| Y | DE-A-2 938 569 (LINS et al.) * Page 2, lignes 6-15; page 3, ligne 15 - page 4, ligne 3; figure * --- | 1,4 | |
| Y | GB-A-2 017 460 (S. YOSHIDA et al.) * Page 2, lignes 3-18; page 4, lignes 1-18 * --- | 1,4 | |
| A . | DE-A-2 318 643 (O. DAUTE) * Page 6, ligne 27 - page 7, ligne 18 * --- | 1-3 | |
| A | US-A-3 349 279 (H.W. SCHAFFT) * Colonne 1, lignes 39-47; colonne 2, ligne 28 - colonne 3, ligne 13 * --- | 1,3 | DOMAINES TECHNIQUES RECHERCHES (Int. Cl.4) |
| A | GB-A-1 162 816 (J.H. TAYLOR) * Page 1, ligne 8 - page 2, ligne 5 * --- | 1,4 | H 04 N<br>H 03 K |
| A | FR-A-1 298 087 (PYE LTD) * Figure 1; page 1, colonne de droite, lignes 16-20 * ----- | 1,5 | |

Le présent rapport a été établi pour toutes les revendications

| Lieu de la recherche | Date d'achèvement de la recherche | Examinateur |
|---|---|---|
| LA HAYE | 09-06-1988 | BOSCH F.M.D. |

**CATEGORIE DES DOCUMENTS CITES**

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

EPO FORM 1503 03.82 (P0402)